# EUROPÄISCHE PATENTSCHRIFT

(11) **EP 0 676 384 B1**
(45) Veröffentlichungstag und Bekanntmachung des Hinweises auf die Patenterteilung: **30.06.1999**
(21) Anmeldenummer: 95200648.4
(22) Anmeldetag: 17.03.1995
(51) Int. Cl.: C04B 41/52, H01L 29/43, H01L 41/18, C03C 17/25, C03C 17/245

(54) **Perowskithaltiger Verbundwerkstoff, Verfahren zu seiner Herstellung, elektronisches Bauelement und Modul**
Perovskite containing composite material, process for its preparation, electronic component and module
Matériau composite contenant du pérovskite, procédé pour sa préparation, composant électronique et module

(30) Priorität: 22.03.1994 DE 4409697
(43) Veröffentlichungstag der Anmeldung: 11.10.1995
(73) Patentinhaber: Philips Patentverwaltung GmbH, 22335 Hamburg (DE); Koninklijke Philips Electronics N.V., 5621 BA Eindhoven (NL)
(72) Erfinder: Klee, Mareike Katharine, Dr., D-20097 Hamburg (DE); Brand, Hans-Wolfgang, D-20097 Hamburg (DE); Larsen, Poul, Dr., D-20097 Hamburg (DE)
(74) Vertreter: Volmer, Georg, Dipl.-Ing.

(56) Entgegenhaltungen:
- US-A- 5 198 269
- THIRD EURO-CERAMICS, Bd. 2, 12.September 1993 SPAIN, Seiten 685-698, XP 000416210 SHIN-ICHI HIRANO, ET AL. 'Processing of better ferroelectric films through chemistry'
- JOURNAL OF THE AMERICAN CERAMIC SOCIETY, Bd. 74, Nr. 6, Juni 1991 COLUMBUS US, Seiten 1455-1458, XP 000236488 A. H. CARIM, ET AL. 'Microstructure of solution-processed lead zirconate titanate (PZT) thin films'

## Beschreibung

Die Erfindung betrifft einen perowskithaltigen Verbundwerkstoff mit einem Substrat, einer Zwischenschicht aus einem ersten, titanhaltigen Perowskit und einer Deckschicht aus einem zweiten Perowskit. Sie betrifft weiterhin ein Verfahren zur Herstellung dieses perowskithaltigen Verbundwerkstoffes, ein elektronisches Bauelement mit diesem Verbundwerkstoff und ein Modul mit integrierten passiven Bauelementen.

Ein solcher perowskithaltiger Verbundwerkstoff ist für eine Vielzahl neuer Anwendungen in der Mikroelektronik von Interesse.

Keramische Perowskite ansich werden in verschiedensten Gebieten der Halbleiterindustrie verwendet, da sie interessante Eigenschaften für spezielle technische Anwendungen, etwa für ferroelektrische, dielektrische, pyroelektrische, piezoelektrische oder optoelektronische Bauelemente, bieten.

Beispielsweise werden Blei-Zirkon-Titan-Perowskite (PZT) unter anderem für nichtflüchtige, ferroelektrische Speicher eingesetzt. PZTs, die mit Lanthan dotiert sind (PLZT) und komplexe titanhaltige Perowskite wie Pb(Mg,Nb)ₓTi₁₋ₓO₃ haben Bedeutung als Dielektrika in Kondensatoren, PLZTs auch als optoelektronische Werkstoffe.

Als Verbundwerkstoffe im Verbund mit den bekannten Substraten haben einige Perowskite besondere Bedeutung für den Aufbau von Modulen mit integrierten passiven Bauelementen erlangt. Dafür werden passive Bauelemente wie Kondensatoren, Widerstände und Spulen in elektronische Schaltungen integriert, indem man sie in Dünnschichttechnik auf einem Substrat wie Silizium oder Aluminiumoxid aufbaut. Eine andere wichtige Anwendung dieser Verbundwerkstoffe sind die Kondensatoren für ferroelektrischen nichtflüchtigen Speicher sowie für dynamische Schreib-Lese-Speicher - mit wahlfreiem Zugriff.

Die zur Herstellung von Perowskiten mit guten Eigenschaften (Dichte, Kristallinität) notwendige Sinterung bei hohen Temperaturen ist jedoch im Verbund mit den meisten bekannten Substraten der Mikroelektronik erschwert, weil diese Substrate diesen Temperaturen nicht standhalten.

Es ist daher notwendig, perowskithaltige Verbundwerkstoffe herzustellen, die schon bei einer Sinterung bei einer Temperatur, die noch unschädlich für das Substrat ist, gute Eigenschaften zeigen.

Bekannt ist dafür beispielsweise aus der US 5,198,269 A ein Verfahren, um einen dünnen Film aus einem ferroelektrischem Perowskitmaterial herzustellen, der die folgenden Schritte umfaßt:
a. Bereitstellung eines Substrates,
b. Auswahl eines ersten Sol-Gel-Perowskit-Ausgangsmaterials, wobei die Kristallisation dieses ersten Sol-Gel-Perowskit-Ausgangsmaterials zu der Perowskitphase unempfindlich gegenüber dem Substrat ist und wobei nach der Wärmebehandlung das Material isostrukturell zu dem zweiten ferroelektrischen Perowskit-Dünnfilmmaterial ist,
c. Auftragen einer ersten Schicht des ausgewählten Sol-Gel-Perowskit-Ausgangsmaterials,
d. thermische Behandlung der ersten aufgetragenen Schicht zur Bildung eines ersten ferroelektrischen Perowskit-Dünnfilmmaterial,
e. Auswahl eines zweiten Sol-Gel-Perowskit-Ausgangsmaterials, wobei die Kristallisation des zweiten Sol-Gel-Pe rowskit-Ausgangsmatrials zur Perowskitphase empfindlich gegenüber dem Substrat ist,
f. Auftrag einer zweiten Schicht aus dem ausgewählten Sol-Gel-Perowskit-Ausgangsmaterials,
g. thermische Behandlung der zweiten aufgetragenen Schicht zur Bildung eines zweiten ferroelektrischen Perowskit-Dün nfilmmaterials, wobei die zweite Schicht des zweiten Sol-Gel-Perowskit-Ausgangsmaterials nach der thermischen Behandlung eine bessere Perowskitkristallinität hat, wenn sie auf sie auf der ersten Schicht aufgetragen wird als wenn sie direkt auf das Substrat aufgetragen und thermisch behandelt worden wäre.

Das erste Sol-Gel-Perowskit-Ausgangsmaterial wird ausgewählt, um in Schritt d. als Perowskit Bleititanat (PbTiO₃) oder Strontiumtitanat (SrTiO₃) zu bilden.

Die nach diesem Verfahren hergestellten perowskithaltigen Verbundwerkstoffe zeigen zwar eine gute Kristallinität in der zweiten Perowskitschicht. Diese zweite Perowskit schicht enthält jedoch häufig sekundäre kristalline Phasen (vgl. US 5 198 269 A, Sp.19, Z.2-5), die sich nachteilig auf die Eigenschaften der Schicht auswirken.

Es ist daher die Aufgabe der vorliegenden Erfindung, einen perowskithaltigen Verbundwerkstoff mit einem Substrat, einer Zwischenschicht aus einem ersten, titanhaltigem Perowskit und einer Deckschicht aus einem zweiten Perowskit zur Verfügung zu stellen, der verbesserte Eigenschaften aufweist.

Diese Aufgabe wird erfindungsgemäß gelöst durch einen perowskithaltigen Verbundwerkstoff, bei dem sowohl der erste als auch der zweite Perowskit ein quaternärer oder höher komplexer Perowskit ist.

In diesem erfindungsgemäßen Verbundwerkstoff wirkt der quaternäre, titanhaltige Perowskit der Zwischenschicht als Keimschicht für die Perowskitbildung in der Deckschicht. Nachdem diese Keimschicht den Perowskiten der Deckschicht in Bezug auf Gitterkonstante und kristallographischer Rau mgruppe nahe stehen, bewirkt sie bei der Sinterung die Bildung von einphasigem Perowskit in der Deckschicht und erniedrigt die Sintertemperatur. Störende Sekundärphasen, z.B. Pyrochlorphasen o.ä. oder amorphe Phasen treten in der Deckschicht nicht auf. Solche Verbundwerkstoffe mit einphasiger Perowskitdeckschicht haben ein optimales Gefüge und zeigen ausgezeichnete Charakteristika beispielsweise für ferroelektrische nichtflüchtige Speicher, weil für diese die Höhe der geschalteten Polarisation besonders hoch ist. Ebenso sind sie besonders für Kondensatoranwendungen geeignet, weil sie eine bemerkenswert hohe relative Dielektrizitätskonstante und damit auch eine hohe Flächenkapazität aufweisen.

Ein weiterer Vorteil des erfindungsgemäßen Verbundwerkstoffes mit homogener, einphasiger Deckschicht ist es, daß sich die Deckschicht sauber und kantenscharf mittels der bekannten Ätztechniken strukturieren läßt. Verbundwerkstoffe mit Sekundärphasen in der perowskithaltigen Deckschicht bilden dagegen bei diesen Verfahren schwerätzbare Rückstände.

Im Rahmen der vorliegenden Erfindung ist es bevorzugt, daß daß sowohl der erste als auch der zweite Perowskit titanhaltig ist und daß der Titangehalt des ersten Perowskits größer ist als der des zweiten Perowskits. Durch diese Ausbildung von Keimschicht und Deckschicht werden besonders gut kristalline Deckschichten erhalten.

Im Rahmen der vorliegenden Erfindung ist es weiterhin bevorzugt, daß der Perowskit der Deckschicht ein bleihaltiger Perowskit ist, weil sich derartige Verbundwerkstoffe wegen der ferroelektrischen Eigenschaften ihrer Deck schicht besonders für eine Vielzahl von Anwendungen in der Mikroelektronik eignen.

Für einige Anwendungen ist es bevorzugt, daß der Perowskit der Zwischenschicht ebenfalls bleihaltig ist, sodaß er mit dem Perowskit der Deckschicht in der Gittersymmetrie übereinstimmt.

Erfindungsgemäße Verbundstoffe, bei denen der Perowskit der Deckschicht PbZrₓTi₁₋ₓO₃ mit 0,53≤x<1 ist, sind besonders für nichtflüchtige ferroelektrische Speicher und für piezoelektrische Anwendungen geeignet.

Erfindungsgemäße Verbundstoffe, bei denen der Perowskit der Deckschicht (Pb_{1-1.5y}La_{y})ZrₓTi₁₋ₓO₃ mit 0,01≤y≤0,15 und 0,53≤x<1 oder Pb(Mg,Nb)ₓTi₁₋ₓO₃ mit 0,65≤x≤0.9 ist, eignen sich besonders für die Fertigung integrierter Kondensatoren und Kondensatoren für dynamische Schreib-Lese-Speicher mit wahlfreiem Zugriff. Nachdem die Perowskitphase pyrochlorfrei ist, haben diese Kondensatoren eine hohe relative Dielektrizitätskonstante und eine hohe Flächenkapazität.

Nach einer vorteilhaften Weiterbildung der Erfindung ist der Perowskit der Zwischenschicht PbZrₓTi₁₋ₓO₃ mit 0<x≤0,35.

Bei der Verwendung dieses Perowskits als Zwischenschicht beginnt die Kristallisation des Perowskits in der Deck schicht bei besonders niedrigen Temperaturen.

Es ist im Rahmen der Erfindung besonders bevorzugt, daß das Substrat eine Schicht aus Silizium-Einkristall enthält. Diese Materialkombination in dem Verbundwerkstoff ist besonders in der Anwendung für ferroelektrische nichtflüchtige Speicher, dynamische Schreib-Lese-Speicher mit wahlfreiem Zugriff und integrierte Kondensatoren geeignet.

Die Erfindung betrifft weiterhin ein Verfahren zur Herstellung des erfindungsgemäßen, perowskithaltigen Verbundwerkstoffes durch Beschichtung eines Substrates mit einem ersten titanhaltigen, quaternären oder höher substituierten Perowskit als Zwischenschicht und einem zweiten, quaternärem oder höher substituiertem Perowskit als Deck schicht, wobei die Beschichtung für die Zwischenschicht vor Aufbringen der Deckschicht gesintert wird.

Die Erfindung ist des weiteren auf ein elektronisches Bauelement aus einem erfindungsgemäßen Verbundwerkstoff gerichtet. Besonders vorteilhaft wird der erfindungsgemäße Verbundwerkstoff in einem ferroelektrischen nichtflüchtigen Speicher eingesetzt, nachdem die einphasigen Perowskite eine besonders hohe Polarisation aufweisen. Ebenso haben diese einphasigen Perowskite verbesserte Eigenschaften für integrierte Kondensatoren, Aktuatoren, Sensoren und optoelektronische Bauelemente.

Schließlich betrifft die Erfindung auch ein sog. "Modul mit integrierten passiven Bauelementen" mit einem integrierten elektronischen Bauelement nach der Erfindung. Für Module mit integrierten passiven Bauelementen ist ein elektronisches Bauelelement mit dem erfindungsgemäßen Verbundwerkstoff besonders geeignet, da es bei niedrigen Temperaturen gesintert und besonders sauber geätzt werden kann.

Nachfolgend wird die Erfindung anhand von Ausführungsbeispielen beschrieben und die Wirkungsweise erläutert.

Der erfindungsgemäße Verbundwerkstoff kann beispielsweise ein Teilchen-, Faser-, Durchdringungsverbundwerkstoff oder insbesondere ein Schichtverbundwerkstoff sein. Dementsprechend kann das Substrat aus Partikeln, Fasern, beispielsweise Glasfasern, einem porösen Körper oder einer Scheibe, beispielsweise einer Siliziumeinkristallscheibe bestehen.

In der Mikroelektronik wird unter einem "Substrat " im allgemeinen eine Scheibe aus einem Material wie Silizium-einkristall, Aluminiumoxidkeramik, Saphir oder Galliumarsenid verstanden. In der Optoelektronik kann das Substrat auch aus einem Glas bestehen.

Im Rahmen der vorliegenden Erfindung soll unter einem "Substrat" auch ein Substrat verstanden werden, das bereits selbst aus mehreren Schichten besteht. Beispielsweise können Siliziumeinkristallsubstrate bereits mit einer Schutzschicht aus SiO₂, einer Haftschicht aus Titan und einer Elektrodenschicht aus Platinmetall beschichtet sein.

Auf ein derartiges Substrat wird erfindungsgemäß eine Zwischenschicht aus einem titanhaltigen, quaternären oder höher substituiertem Perowskit und anschließend eine Deckschicht aus einem quaternären oder höher substituierten Perowskit aufgebracht.

Die einfachsten Perowskite sind ternäre Oxide der allgemeinen Zusammensetzung ABO₃. Abwandlungen der Verbindungen mit Perowskitstruktur entstehen dadurch, daß die A- und/oder die B-Kationen teilweise durch ein oder mehrere andere Kationen substituiert werden können, sodaß aus den zunächst ternären Perowskiten ABO₃ höhermultiple Perowskite, z.B. quaternäre, quinäre, senäre septenäre usw. Perowskite werden.

Die Perowskitstruktur ist in Bezug auf die Substitution sehr anpassungsfähig, sie kann auf den Gitterplätzen der A-Kationen gleichzeitig bis zu 20 verschiedene Kationen, auf den Gitterplätzen der B-Kationen gleichzeitig bis zu 40 verschiedene Kationen enthalten. Einen Überblick über die Vielzahl der substituierten Perowskite und deren Verwendungsmöglichkeiten ist in R.M. Hazen, "Perowskite", Spektrum der Wissenschaften, August 1988, S. 42-50 enthalten. Eine weitere Übersicht über Perowskitmaterialien ist in "Process mineralogy of ceramic materials" ed. by W.Baumgart et. al., Stuttgart:Enke(1984) 115ff. enthalten.

Im Rahmen der vorliegenden Erfindung werden quaternäre oder höher substituierte Perowskite verwendet, die aufgrund ihrer dielektrischen, ferroelektrischen, piezoelektrischen, pyroelektrischen oder doppelbrechenden Eigenschaften ausgewählt werden.

Eine große Gruppe der substituierten Perowskite basiert auf BaTiO₃ und ist z.B. für Verwendungen als Filter, Kondensator, nichtlinearer Widerstand u.ä. geeignet.

Kommerziell besonders wichtig sind die PZTs, d.h. Blei-Zirkon-Titanate Pb(Ti,Zr)O₃ die als Piezokeramik für Aktuatoren oder auch beispielsweise als Ferroelektrika für Speicher Verwendung finden. Lanthandotierte PZTs (LPZT) sind transparent und zeigen einen linearen bzw. quadrati schen elektrooptischen Effekt. Sie werden deshalb auch für optoelektronische Zwecke eingesetzt.

Die Zwischenschicht und die Deckschicht können durch trokkene oder naßchemische Dispositionsverfahren aufgebracht werden.

Zu den trockenen Depositionsverfahren zählt die Kathodenzerstäubung, in denen die erforderliche Energie mittels Radiofrequenz bzw. eines Ionenstrahls bereitgestellt wird. Des weiteren zählen die thermische und die Elektronenstrahl-Verdampfung, die Metallorganische CVD (MOCVD) und die Laserablation zu den trockenen Depositionsverfahren.

Auch die naßchemischen Depositionsverfahren offerieren die Möglichkeit, kritische Parameter wie die chemische Zusammensetzung, Stöchiometrie, Reinheit und Homogenität der Dünnschichtkeramik sowohl der Zwischenschicht als auch der Deckschicht reproduzierbar zu kontrollieren. Zu diesen Verfahren zählt das Sol-Gel-Verfahren und die metallo-organische Decomposition (MOD), vgl.J.Appl.Phys.72(4), (4), 1566 (1992).

Für diese naßchemischen Methoden werden als chemische Ausgangsverbindungen hauptsächlich Metallalkoholate verwendet. In einer Poly-Kondensation wird daraus die Sol-Gel-Lösung gebildet. Der MOD- Prozeß verwendet Verbindungen mit höherem Molekulargewicht, z.B. Oktanoate oder Dekanoate, die gegenüber der Hydrolysereaktion unempfindlich reagieren, aber u.U. beim Ausbrennen der Schichten schwerer zu pyrolysieren sind.

Zur Kompensation von Bleiverlusten während des Brennprozesses und zur Unterstützung der Kristallisation der Perowskite kann die Mischung der Ausgangsverbindugen einen Bleiüberschuß von vorzugsweise 5 bis 20 Gew.-% Pb enthalten.
Diese Lösungen werden mit Hilfe konventioneller Verfahren, wie Schleuderprozeß, Tauch- oder Sprühverfahren auf das Substrat aufgebracht. Pro Depositionsschritt werden Schichten von ca. 0.05µm bis 0,2µm realisiert. Für die Bildung dickerer Deckschichten muß daher dieser Prozeß mehrfach wiederholt werden.

Die deponierten Schichten sind zunächst amorph, zur Bildung der Perowskite ist eine Temperaturbehandlung notwendig, bei der eine Temperatur zwischen 600°C und 800°C, abhängig von der Art des Perowskits erreicht werden muß. Andererseits beeinflußt die Temperaturbehandlung die Eigenschaften des Substrates negativ, sodaß die Temperaturbehandlung bei möglichst niedrigen Temperaturen durchgeführt werden soll. Die Ofenkurven müssen deshalb für jeden Anwendungsfall optimiert werden. Die Perowskitbildung wird dabei röntgenographisch kontrolliert.

Der so erhaltene Verbundwerkstoff kann dann zu elektronischen Bauelementen, wie z.B. Kondensatoren, insbesondere integrierten Kondensatoren und Kondensatoren für dynamische Schreib-Lese-Speicher mit wahlfreiem Zugriff, ferroelektrischen nichtflüchtigen Speicher, Aktuatoren, Widerständen, piezoelektrische Wandlern, pyroelektrischen oder piezoelektrischen Sensoren oder optoelektronischen Bauelementen weiterbearbeitet werden.

Eine besonders wichtige Verwendung findet der erfindungsgemäße Verbundwerkstoff für integrierte Bauelemente, z.B. als ferroelektrischer Speicherkondensator oder als in Halbleiter-ICs integrierte Kondensatoren, als Kondensator in "Modulen mit integrierten passiven Bauelementen", als Kondensatoren für dynamische Schreib-Lese-Speicher mit wahlfreiem Zugriff, als integrierter Aktuator z.B. in Mikromotoren, als integrierter pyroelektrischer oder piezoelektrischer Sensor und für ähnliche Bauteile. Dazu muß der Verbundwerkstoff teilweise mit der Silizium- bzw. Galliumarsenid-Technologie integriert werden. Integrierte Bauelemente können in den unterschiedlichsten Designs realisiert werden. Dazu sind im allgemeinen zusätzlich zu dem konventionellen Prozeßschritten mehrere
Lithographieschritte notwendig, mit der eine Unterelektrode, eine Oberelektrode und eine Isolationsschicht gebildet werden.
Diese Schichten werden dann strukturiert, beispielsweise durch Argon-Ionenätzen oder Plasmaätzen.

Nachdem der erfindungsgemäße Verbundwerkstoff einphasige Perowskite ohne die geringste Menge einer Zweitphase aufweist, läßt er sich ohne Ätzrückstände strukturieren. Dadurch wird zum Beispiel die weitere Bestückung der Module mit integrierten passiven Bauelementen mit aktiven Komponenten sehr erleichtert.

### Beispiel 1

Zur Herstellung der erfindungsgemäßen Schichtverbundwerkstoffe wird zunächst die Zwischenschicht auf ein Substrat aufgetragen. Dazu wird eine Lösung mit den Ausgangsverbindungen für den Perowskit PbZr_{0.35}Ti_{0.65}O₃ für die Zwischenschicht hergestellt, indem 17,97g Bleiacetat-trihydrat (54,8 Gew.-%Pb) in 60g Methoxyethanol gelöst werden und zu dieser Lösung 9,34 g Titantetra-n-butylat (14.1 Gew.-% Ti) und 6,57 g Zirkontetra-(n)-butylat (20,53 Gew.-% Zr) zugefügt werden. Die Lösung enthält damit einen Bleiüberschuß. Diese Lösung in Methoxyethanol wird homogen ge mischt. Nach 24 Stunden wird die Lösung durch ein Teflonfilter mit einer Porenweite von 0,2µm filtriert.

Mit dieser Lösung wird ein Substrat beschichtet, das eine Schichtanordnung aus einer (100)-Einkristallscheibe aus Silizium, 500nm SiO₂, 7nm Titanschicht und 70 nm Platinschicht aufweist. Die Beschichtung erfolgt durch "Spin-coating" (Schleudern) bei 2500 Umdrehungen /min. Das beschichtete Substrat wird in einem Diffusionsofen mit ca. 400°C/min aufgeheizt, 1h bei 600°C gehalten und dann mit ca. 400°C/min abgekühlt.

Die so erhaltene Zwischenschicht hat eine Schichtdicke von ca. 0,1µm.

### Beispiel 2

Zur Abscheidung einer einphasigen Perowskitschicht mit einem Perowskit der Zusammensetzung PbZr_{0.53}Ti_{0.47}O₃ auf einem Substrat mit einer Zwischenschicht nach Beispiel 1 wird eine Lösung der Ausgangsverbindungen auf folgende Weise hergestellt:
9.41 g Bleiacetat (63.9 Gew.-%Pb) wurden in 13ml Methoxyethanol gelöst. 4.22g Titantetra-n-butylat (14.1 Gew.-% Ti) und 6,57 g Zirkontetra-n-butylat (20,53 Gew.-% Zr) wurden in 3ml Methoxethanol gelöst. Die titan- und zirkonhaltige Lösung wurde zur Bleiacetatlösung unter Rühren zugefügt. Die Lösung enthält somit einen Bleiüberschuß. Weiterhin wurde eine Hydrolisierlösung aus 0.71 ml aq. dest., 0,37ml conc. HNO₃ und 26,4ml Methoxyethanol hergestellt. Diese Hydrolisierlösung wurde zu der blei-, titan- und zirkonhaltigen Lösung zugefügt. Die so vorhydrolysierte Lösung wurde durch ein Teflonfilter mit einer Porenweite von 0.2 µm filtriert. Diese Lösung wurde auf das nach Beispiel 1 vorbehandelte Substrat mit Zwischenschicht aus einer 0.1 µm dicken PbZr_{0.35}Ti_{0.65}O₃ aufgebracht. Sie wurde dazu mittels Schleudern bei 2500 Umdrehungen/min homogen auf dem vorbehandelten Substrat verteilt. Diese Deckschicht wurde ebenfalls bei 600°C in Sauerstoffatmosphäre eine Stunde eingebrannt. Dieser Beschichtungsprozeß kann je nach gewünschter Schichtdicke der Deckschicht wiederholt werden. Bei dem letzten Beschichtungsprozeß wird die Schicht eine Stunde bei 600°C vorgebrannt, dann mit 5°C/min auf 650°C aufgeheizt und bei 650°C eine Stunde endbehandelt.

### Beispiel 3

Ein Si(100)-Substrat mit einer Schichtanordnung mit 500nm SiO₂, 10nm Ti und 140nm Pt wurde mit einer Zwischenschicht, wie in Bsp.1 beschrieben, versehen. Darauf wurde eine Deckschicht aus einphasigem Pb Pb(Mg_{0.33}Nb_{0.67})_{0.65}Ti_{0.35}O₃ im Sol-Gel-Verfahren abgeschieden. Für die Beschichtungslösung wurden zunächst 1.822g Magnesiumethoxid (21.46 Gew.-% Mg), 10.24g Niobethoxid (29.64 Gew.-% Nb) und 7.46g Titanisopropxid (16.86 Gew.-% Ti) in 104g Ethylenglykolmonomethylether gelöst und 24h unter Rückfluß erhitzt. Weiterhin wurden 56.93 g Bleiacetat (63.85 Gew.-% Pb) in 185g Ethylenglykolmonomethylether gelöst. 61.12g der Mg-Nb-Ti-Lösung wurden mit 56.26g der Bleiacetatlösung unter Rühren vermischt und 20h unter Rückfluß erhitzt. Dann wurde die Lösung durch ein Teflonfilter mit einer Porenweite von 0.2µm filtriert und das Filtrat im Schleuderverfahren bei 2500 Umdrehungen/min auf das vorpräparierte Substrat aufgebracht. Diese Beschichtung wurde eine Minute bei 800°C gesintert. Der Beschichtungsprozeß wurde sechsmal wiederholt. Mit diesem Verfahren wurde eine einphasige Pb(Mg_{0.33}Nb_{0.67})_{0.65}Ti_{0.35}O₃ -Schicht auf einem Si-Substrat der oben beschriebenen Art aufgebaut.

### Beispiel 4

Ein Si(100)-Substrat mit einer Schichtanordnung mit 500nm SiO₂, 10nm Ti und 140nm Pt wurde mit einer Zwischenschicht, wie in Bsp.1 beschrieben, versehen. Darauf wurde eine Deckschicht aus einphasigem Pb_{0.82}La_{0.12}Zr_{0.7}Ti_{0.3}O₃ im Sol-Gel-Verfahren abgeschieden. Für die Beschichtungslösung wurden 7.14g Bleiacetat (63.85Gew.-% Pb) in 30 ml Methoxyethanol gelöst. 7,713g Zirkon-n-propoxid (20,68 Gew.-% Zr) wurden in 5ml Methoxyethanol gelöst. Zu dieser Lösung wurden 2.130g Titanisopropoxid (16.85 Gew.-% Ti) und 1,28g Lanthanacetathydrat (32.3 Gew.-% La) zugefügt. Diese Ti-Zr-La-Lösung wurde mit der Pb-Lösung gemischt und anschließend im Verhältnis 1:1 mit Methoxyethanol verdünnt. Diese Blei im Überschuß enthaltende Lösung wurde durch ein Teflonfilter mit einer Porenweite von 0.2 µm filtriert. Das Filtrat wurde im Schleuderverfahren mit 2500 Umdrehungen/min homogen auf dem vorpräpariertem Substrat verteilt. Diese Beschichtung wurde im Diffusionsofen mit Sauerstoffatmosphäre mit ca. 400°C/min auf 700°C aufgeheizt, 40 min bei 700°C gehalten und dann mit ca.400°C/min abgekühlt. Diese Beschichtungsschritt kann je nach gewünschter Schichtdicke wiederholt werden. Nach dem letzten Beschichtungsauftrag wird zur Endbehandlung zunächst mit 400°C/min auf 700°C aufgeheizt, 40 min gehalten, dann mit 5°C/min auf 750°C aufgeheizt, eine Stunde bei 750°C gehalten und dann im Ofen abgekühlt.

### Beispiel 5

Die Abscheidung einer einphasigen Perowskitschicht mit einem Perowskit der Zusammensetzung PbZr_{0.48}T1_{0.52}O₃ erfolgt auf einem Substrat mit einer Zwischenschicht der Zusammensetzung PbZr_{0.35}Ti_{0.65}O₃. Diese Zwischenschicht aus PbZr_{0.35}Ti_{0.65}O₃ mit einer Dicke von 0.1 µm wurde auf folgende Weise hergestellt. Die in Bsp. 1 beschriebene Lösung wird mit 2500 Umdrehungen pro Minute durch einen Schleuderprozeß abgeschieden. Zur Bildung der Perowskit-phase wird das beschichtete Substrat in einem Diffusionsofen mit ca. 350°C/min aufgeheizt, 1 h bei 550°C gehalten und dann mit ca. 350°C/min abgekühlt. Auf dieses vorbehandelte Substrat wird zur Abscheidung einer Perowskitschicht der Zusammensetzung PbZr_{0.48}Ti_{0.52}O₃ eine Lösung auf folgende Weise hergestellt.
8,560 g Bleiacetat (63,9 Gew.% Pb) wurden in 13,1 ml Methoxyethanol gelöst. 4,204 g Titantetra-n-butylat (14,1 Gew.% Ti) und 5,076 g Zirkon-tetra-n-butylat (20,53 Gew.% Ti) wurden in 3 ml Methoxyethanol gelöst. Die Titan und Zirkon enthaltende Lösung wurde zur Bleiacetatlösung unter Rühren zugefügt. Weiterhin wurde eine Hydrolisierlösung aus 0.64 ml aq.dest., 0.33 ml conc. HNO₃ und 26.4 ml Methoxyethanol hergestellt. Diese Hydrolisierlösung wurde zu der Blei, Titan und Zirkon enthaltenden Lösung zugefügt. Die so vorhydrolisierte Lösung wurde durch ein Teflonfilter mit einer Porenweite von 0.2 µm filtriert.
Diese Blei im Überschuß enthaltende Lösung wurde dann mittels Schleudern bei 2500 Umdrehungen/min homogen auf dem oben beschriebenen, vorbehandelten Substrat verteilt. Diese Deckschicht wurde bei 550°C eine Stunde eingebrannt. Dieser Beschichtungsprozeß kann je nach gewünschter Schichtdicke der Deckschicht wiederholt werden. Bei dem letzten Beschichtungsprozeß wird die Schicht bei 600°C vorgebrannt, dann mit 5°C/min auf 650°C aufgeheizt und bei dieser Temperatur 5 Minuten behandelt.

Dieser Verbundwerkstoff eignet sich besonders für pyroelektrische Anwendungen.

### Beispiel 6

Zur Abscheidung einer einphasigen Perowskitschicht mit Zusammensetzung Pb(Sc_{0.5}Ta_{0.5})O₃ wird wiederum eine-Lösung hergestellt. Diese Lösung wird zur Abscheidung von einer einphasigen Perowskitschicht auf einem Substrat mit einer Zwischenschicht mit der Zusammensetzung PbZr_{0.35}Ti_{0.65}O₃ nach Beispiel 1 aufgebracht. Die Lösung wird auf folgende Weise hergestellt. 10.00 g Bleiacetat (63,9 Gew.% Pb) wurden in 14 ml Methoxyethanol gelöst. 4,548 g Scandium-2,4-pentandionat (12.95 Gew.% Sc) und 5,3268 g Tantalpenta-ethoxid (44.5 Gew.% Ta) wurden in 31 ml Methoxyethanol gelöst und 3 Stunden unter Rückfluß reagieren lassen. Die Scandium und Tantal enthaltende Lösung wurde zur Bleiacetatlösung unter Rühren zugefügt, 12 Stunden unter Rühren umgesetzt und anschließend durch eine Teflonfilter mi einer Porenweite von 20.2 µm filtriert.
Diese Blei im Überschuß enthaltende Lösung wurde auf ein nach Beispiel 1 vorbehandeltes Substrat mit einer Zwischenschicht aus einer ca. 0.1 µm dicken PbZr_{0.35}Ti_{0.65}O₃ aufgebracht. Sie wurde dazu mittels Schleudern bei 2500 Umdrehungen/min homogen auf dem vorbehandelten Substrat verteilt. Diese Beschichtung wurde 1 Minute bei 850°C gesintert. Dieser Beschichtungsprozeß kann je nach gewünschter Schichtdicke der Deckschicht wiederholt werden. Dieser Verbundwerkstoff eignet sich ebenfalls besonders für pyroelektrische Anwendungen.

### Beispiel 7

Zur Abscheidung einer einphasigen Perowskitschicht mit einem Perowskit der Zusammensetzung Pb_{0.93}La_{0.05}Zr_{0.53}Ti_{0.47}O₃ auf einem Substrat mit einer Zwischenschicht der Zusammensetzung PbZr_{0.35}Ti_{0.65}O₃ nach Beispiel 1 wurde eine Lösung der Ausgangsverbindungen auf folgende Weise hergestellt. 10,00 g Bleiacetat (63,9 Gew.% Pb) wurden in 35 ml Methoxyethanol gelöst. 6.480, g Zirkon-n-propoxid (20.68 Gew% Zr) wurden in 7 ml Methoxyethanol gelöst. Zu dieser Zirkon enthaltende Lösug wurden 3.701 g Titan-tetra-n-butylat (14,1 Gew.% Ti) und 0.596 g Lanthanacetathydrat (32.3 Gew.% La) zugefügt. Diese Titan, Zirkon und Lanthan enthaltende Lösung wurde mit der Bleiacetatlösung unter Rühren vermischt und anschließend im Verhältnis 1:1 mit Methoxyethanol verdünnt. Diese Blei im Überschuß enthaltende Lösung wurde durch ein Teflonfilter mit einer Porenweite von 0.2 µm filtriert. Das Filtrat wurde im Schleuderverfahren mit 2500 Umdrehungen/min homogen auf dem vorpräparierten Substrat verteilt. Diese Beschichtung wurde im Diffusionsofen mit Sauerstoffatmosphäre mit ca. 370°C/min auf 600°C aufgeheizt und 1 Stunde bei dieser Temperatur gehalten und dann mit Schichtdicke der Deckschicht wiederholt. Bei dem letzten Beschichtungsprozeß wird die Schicht eine Stunde bei 600°C vorgebrannt, dann mit 5°C/min auf 650°C aufgeheizt und bei 650°C eine Stunde behandelt. Dieser Verbundwerkstoff eignet sich besonders für piezoelektrische Anwendungen.

## Patentansprüche

1. Perowskithaltiger Verbundwerkstoff
mit einem Substrat,
einer Zwischenschicht aus einem ersten titanhaltigem Perowskit und
einer Deckschicht aus einem zweiten Perowskit
dadurch gekennzeichnet,
daß sowohl der erste als auch der zweite Perowskit ein quaternärer oder höher substituierter Perowskit ist.

2. Perowskithaltiger Verbundwerkstoff nach Anspruch 1,
dadurch gekennzeichnet,
daß sowohl der erste als auch der zweite Perowskit titanhaltig ist und
daß der Titangehalt des ersten Perowskits größer ist als der des zweiten Perowskits.

3. Perowskithaltiger Verbundwerkstoff
nach Anspruch 1 oder 2,
dadurch gekennzeichnet,
daß der Perowskit der Deckschicht bleihaltig ist.

4. Perowskithaltiger Verbundwerkstoff
nach Anspruch 1 bis 3,
dadurch gekennzeichnet,
daß der Perowskit der Zwischenschicht bleihaltig ist.

5. Perowskithaltiger Verbundwerkstoff
nach Anspruch 1 bis 4,
dadurch gekennzeichnet,
daß der Perowskit der Deckschicht
PbZrₓTi₁₋ₓO₃ mit 0,53≤x<1 ist.

6. Perowskithaltiger Verbundwerkstoff
nach Anspruch 1 bis 4,
dadurch gekennzeichnet,
daß der Perowskit der Deckschicht
(Pb_{1-1.5y}La_{y})ZrₓTi₁₋ₓO₃ mit 0,01≤y≤0,15 und 0,53≤x<1 oder Pb(Mg,Nb)ₓTi₁₋ₓO₃ mit 0,65≤x≤0.9 ist.

7. Perowskithaltiger Verbundwerkstoff
nach Anspruch 1 bis 6,
dadurch gekennzeichnet,
daß der Perowskit der Zwischenschicht PbZrₓTi₁₋ₓO₃ mit 0<x≤0,35 ist.

8. Perowskithaltiger Verbundwerkstoff
nach Anspruch 1 bis 7,
dadurch gekennzeichnet,
daß der Perowskit der Zwischenschicht PbZr_{0.35}Ti_{0.65}O₃ ist.

9. Perowskithaltiger Verbundwerkstoff
nach Anspruch 1 bis 8,
dadurch gekennzeichnet,
daß das Substrat eine Schicht aus Silizium-Einkristall enthält.

10. Verfahren zur Herstellung eines perowskithaltigen Verbundwerkstoffes nach Anspruch 1 bis 9
durch Beschichtung eines Substrates mit einem ersten titanhaltigen, quaternären oder höher substituierten Perowskit als Zwischenschicht und einem zweiten quaternärem oder höher substituiertem Perowskit als Deckschicht, wobei die Beschichtung für die Zwischenschicht vor Aufbringen der Deckschicht gesintert wird.

11. Verfahren nach Anspruch 10
dadurch gekennzeichnet,
daß die Beschichtung im Sol-Gel-Verfahren, modifiziertem Sol-Gel-Verfahren oder durch metallo-organische Decomposition aufgebracht wird,

12. Verfahren nach Anspruch 10 und 11,
dadurch gekennzeichnet,
daß die Beschichtungslösungen im Schleuderverfahren aufgetragen werden.

13. Elektronisches Bauelement mit einem perowskithaltigen Verbundwerkstoff nach Anspruch 1 bis 9.

14. Elektronisches Bauelement nach Anspruch 13,
dadurch gekennzeichnet,
daß es ein Kondensator, insbesondere ein integrierter Kondensator, ein ferroelektrischer nichtflüchtiger Speicher, ein dynamischer Schreib-Lese-Speicher mit wahlfreiem Zugriff, ein Aktuator, ein nichtlinearer Widerstand, ein piezoelektrischer Wandler, ein pyroelektrischer oder ein piezoelektrischer Sensor oder ein optoelektronisches Bauelement ist.

15. Modul mit integrierten passiven Bauelementen mit einem elektronischen Bauelement nach Anspruch 13 oder 14.

## Claims

1. A perovskite-containing composite material comprising a substrate, an intermediate layer of a first titanium-containing perovskite and a covering layer of a second perovskite, characterized in that both the first and the second perovskites are a quaternary or higher-substituted perovskite.

2. A perovskite-containing composite material as claimed in Claim 1, characterized in that both the first and the second perovskites contain titanium and in that the titanium content of the first perovskite exceeds that of the second perovskite.

3. A perovskite-containing composite material as claimed in Claim 1 or 2, characterized in that the perovskite of the covering layer contains lead.

4. A perovskite-containing composite material as claimed in Claims 1 to 3, characterized in that the perovskite of the intermediate layer contains lead.

5. A perovskite-containing composite material as claimed in Claims 1 to 4, characterized in that the perovskite of the covering layer is PbZrₓTi₁₋ₓO₃, wherein 0.53 ≤ x < 1.

6. A perovskite-containing composite material as claimed in Claims 1 to 4, characterized in that the perovskite of the covering layer is (Pb_{1-1.5y}La_{y})ZrₓTi₁₋ₓO₃, wherein 0.01 ≤ y ≤ 0.15 and 0.53 ≤ x < 1, or Pb(Mg, Nb)ₓTi₁₋ₓO₃, wherein 0.65 ≤ x ≤ 0.9.

7. A perovskite-containing composite material as claimed in Claims 1 to 6, characterized in that the perovskite of the intermediate layer is PbZrₓTi₁₋ₓO₃, wherein 0 < x ≤ 0.35.

8. A perovskite-containing composite material as claimed in Claims 1 to 7, characterized in that the perovskite of the intermediate layer is PbZr_{0.35}Ti_{0.65}O₃.

9. A perovskite-containing composite material as claimed in Claims 1 to 8, characterized in that the substrate comprises a silicon-monocrystal layer.

10. A method of manufacturing a perovskite-containing composite material as claimed in Claims 1 to 9, by providing a substrate with a first titanium-containing, quaternary or higher-substituted perovskite as the intermediate layer, and with a second quaternary or higher-substituted perovskite as the covering layer, the coating for the intermediate layer being sintered before the covering layer is provided.

11. A method as claimed in Claim 10, characterized in that the coating is provided by means of a sol-gel process, modified sol-gel process or by metallo-organic decomposition.

12. A method as claimed in Claims 10 and 11, characterized in that the coating solutions are provided by spin coating.

13. An electronic component comprising a perovskite-containing composite material as claimed in Claims 1 to 9.

14. An electronic component as claimed in Claim 13, characterized in that it is a capacitor, in particular an integrated capacitor, a ferroelectric non-volatile memory, a dynamic, random-access write-read memory, an actuator, a non-linear resistor, a piezoelectric transducer, a pyroelectric or piezoelectric sensor or an optoelectronic component.

15. A module comprising integrated passive components including an electronic component as claimed in Claim 13 or 14.

## Revendications

1. .Matériau composite contenant du pérovskite
avec un substrat
une couche intermédiaire formée d'un premier pérovskite contenant du titane et
une couche de recouvrement d'un deuxième pérovskite
caractérisé en ce
que les premier et deuxième pérovskites sont des pérovskites substitués quaternaires ou supérieurs.

2. Matériau composite contenant du pérovskite selon la revendication 1,
caractérisé en ce
que les premier et deuxième pérovskites contiennent du titane et
que la teneur en titane du premier pérovskite est supérieure à celle du deuxième pérovskite.

3. Matériau composite contenant du pérovskite
selon l'une des revendications 1 ou 2,
caractérisé en ce
que le pérovskite de la couche de recouvrement contient du plomb.

4. Matériau composite contenant du pérovskite
selon l'une des revendications 1 à 3,
caractérisé en ce
que le pérovskite de la couche intermédiaire contient du plomb.

5. Matériau composite contenant du pérovskite,
selon l'une des revendications 1 à 4,
caractérisé en ce
que le pérovskite de la couche de recouvrement
est PbZrₓTi₁₋ₓO₋₃ avec 0,53 ≤ x < 1.

6. Matériau composite contenant du pérovskite,
selon l'une des revendications 1 à 4,
caractérisé en ce
que le pérovskite de la couche de recouvrement
est (Pb_{1-1.Sy}La_{y})ZrₓTi₁₋ₓO₃ avec 0,01 ≤ y ≤ 0,15 et 0,53 ≤ x < 1 ou Pb(Mg,Nb)ₓTi₁₋ₓO₃ avec 0,65 ≤ x ≤ 0,9.

7. Matériau composite contenant du pérovskite,
selon l'une des revendications 1 à 6,
caractérisé en ce
que le pérovskite de la couche intermédiaire est PbZrₓTi₁₋ₓO₃ avec 0 < x ≤ 0,35.

8. Matériau composite contenant du pérovskite,
selon l'une des revendications 1 à 7,
caractérisé en ce
que le pérovskite de la couche intermédiaire est PbZr_{0,35}Ti_{0,65}O₃.

9. Matériau composite contenant du pérovskite
selon l'une des revendications 1 à 8,
caractérisé en ce
que le substrat contient une couche monocristalline de silicium.

10. Procédé de fabrication d'un matériau composite contenant du pérovskite selon l'une des revendications 1 à 9,
par revêtement d'une substrat avec un premier pérovskite substitué quaternaire ou supérieur contenant du titane comme couche intermédiaire et un deuxième pérovskite substitué quaternaire ou supérieur comme couche de recouvrement, le revêtement pour la couche intermédiaire étant fritté avant l'application de la couche de recouvrement.

11. Procédé selon la revendication 10,
caractérisé en ce
que le revêtement est appliqué dans le procédé sol-gel, le procédé sol-gel modifié ou par décomposition métallo-organique.

12. Procédé selon l'une des revendications 10 et 11,
caractérisé en ce
que les solutions de revêtement sont appliquées dans le procédé de centrifugation.

13. Composant électronique avec un matériau composite contenant du pérovskite selon l'une des revendications 1 à 9.

14. Composant électronique selon la revendication 13,
caractérisé en ce
qu'il s'agit d'un condensateur, en particulier d'un condensateur intégré, d'une mémoire non volatile ferroélectrique, d'une mémoire de lecture/écriture dynamique à accès aléatoire, d'un actionneur, d'une résistance non linéaire, d'un convertisseur piézoélectrique; d'une sonde pyroélectrique ou piézoélectrique ou d'un composant optoélectronique.

15. Module avec composants passifs intégrés avec un composant électronique selon l'une des revendications 13 ou 14.
